# EUROPEAN PATENT SPECIFICATION

(11) **EP 4 255 152 B1**
(45) Date of publication and mention of the grant of the patent: **15.04.2026**
(21) Application number: 22210313.7
(22) Date of filing: 29.11.2022
(51) Int. Cl.: H10K 50/844, H10K 59/80

(54) **LIGHT EMITTING DISPLAY APPARATUS**
LICHTEMITTIERENDE ANZEIGEVORRICHTUNG
APPAREIL D'AFFICHAGE ÉLECTROLUMINESCENT

(30) Priority: 31.03.2022 KR 20220040466
(43) Date of publication of application: 04.10.2023
(73) Proprietor: LG Display Co., Ltd., SEOUL, 07336 (KR)
(72) Inventor: Yoo, Chungryeol, 10845 Gyeonggi-do (KR); Kwon, Soonho, 10845 Gyeonggi-do (KR); Kim, Jaehee, 10845 Gyeonggi-do (KR)
(74) Representative: Ter Meer Steinmeister & Partner

(56) References cited:
- EP-A1- 3 522 229
- US-A1- 2018 151 838
- US-A1- 2020 381 653
- US-A1- 2021 043 715
- US-A1- 2021 202 895

## Description

### BACKGROUND

### Field

The present disclosure relates to a light emitting display apparatus, and more particularly, to a light emitting display apparatus which controls a flow of a protection layer disposed on a light emitting diode layer and improves a sensitivity of a touch line disposed in an outer peripheral area of the light emitting display apparatus.

### Description of the Related Art

A recent display apparatus which is capable of displaying various information and interacting with a user who watches the information is needed to have various sizes, various shapes, and various functions.

Examples of the display apparatus include a liquid crystal display device LCD, an electrophoretic display device FPD, a light emitting diode display device LED, and the like.

The light emitting display apparatus LED is a self-emitting display device so that a separate light source is not necessary, unlike the liquid crystal display device LCD. Therefore, the light emitting display apparatus may be manufactured to have light weight and small thickness. Further, since the light emitting display apparatus is driven at a low voltage, it is advantageous not only in terms of power consumption, but also in the color implementation, the response speed, the viewing angle, and the contrast ratio CR, so that it is being studied as next generation displays.

When the light emitting display apparatus is an organic light emitting display apparatus, the light emitting diode layer may be an organic light emitting diode layer including an anode, an emission layer, and a cathode. In addition, as the light emitting diode layer, a quantum-dot light emitting diode QLED including quantum dots QD may be further used. Hereinafter, even though the description will be made under the assumption that the light emitting display apparatus is the organic light emitting display apparatus, the type of the light emitting diode layer is not limited thereto.

The organic light emitting display apparatus displays information on a screen by emitting light from a plurality of pixels including a light emitting diode layer having an emission layer. The organic light emitting display apparatus may be classified into an active matrix type organic light emitting diode display AMOLED apparatus or a passive matrix type organic light emitting diode display PMOLED apparatus depending on a method of driving a pixel.

The active matrix type organic light emitting diode display AMOLED apparatus controls a current flowing in an organic light emitting diode using a thin film transistor (TFT) to display images.

The active matrix type organic light emitting diode display apparatus includes various thin film transistors such as a switching thin film transistor, a driving TFT connected to the switching TFT, and an organic light emitting diode (OLED) connected to the driving TFT.

A gate electrode, a source electrode, a drain electrode, and a semiconductor layer which configure various TFTs having various purposes and a large number of electrode lines connected thereto are disposed and a planarization layer is provided on the thin film transistor.

A light emitting diode layer is disposed on the planarization layer. The light emitting diode layer may include an anode electrode (anode) which is a pixel electrode, an emission layer, and a cathode electrode (cathode).

The organic light emitting display apparatus uses an organic material for the emission layer. During the process of injecting electrons and holes into the emission layer configured by the organic material through two electrodes (for example, the anode electrode and the cathode electrode) so that the electrons and the holes are met on the emission layer to be recombined, excitons are formed and the light is emitted due to the energy from the excitons.

The electrons and holes are injected through the anode electrode which is a pixel electrode and the cathode electrode which is a common electrode. In order to more smoothly inject the electrons and the holes, the organic layer may include a hole injection layer, a hole transport layer, an electron transport layer, and an electron injection layer and may have a multi-layered structure thoseof. The organic light emitting display apparatus has disadvantages in that there may be deterioration due to internal factors such as deterioration of the electrode and the emission layer due to oxygen or deterioration by the reaction between the emission layer and interface and deterioration due to external factors such as moisture, oxygen, and ultraviolet rays from the outside. Therefore, packaging and encapsulation of the organic light emitting display apparatus are very important.

A protection layer including at least one inorganic layer and at least one organic layer is formed to protect the light emitting diode layer.

An organic material which configures the protection layer is configured by a polymer material and is formed by a hardening process after being applied on the substrate as a liquid. The organic material has a fluidity before the hardening process so that there is a problem in that a liquid polymer which configures the organic material invades an area in which a driving circuit is formed in an outer periphery of the substrate to cause a driving failure.

In order to provide more various functions to the users, as the light emitting display apparatus, a touch display apparatus which provides a touch-based input method to allow the users to intuitively and easily input information or instructions by breaking away from the usual input method such as a button, a keyboard, or a mouse is being studied.

A plurality of touch lines is disposed on the protection layer to detect the presence of touch or to detect a touch coordinate based on the change in the capacitance formed in the plurality of touch lines formed on a substrate.

A planarization layer, an insulating layer, and a metal line which are disposed below the protection layer in an outer peripheral area of the light emitting display apparatus are etched so that steep inclinations and steps may be formed. Therefore, there are problems in that the edge of the light emitting display is not applied with the protection layer or a thickness thereof is sharply reduced. Accordingly, there is a problem in that a touch sensitivity of the touch line disposed on the protection layer in the outer peripheral area of the light emitting display apparatus is lowered.

Consequently, even though various reviews have been performed to control the flow of the protection layer of the light emitting display apparatus and improve the touch sensitivity in the outer peripheral area of the light emitting display apparatus, it is still insufficient so that development thereof is urgently required.

US 2021/202895 A1 relates to an organic light emitting display having a structure by which the inclination of a first side surface of the planarization layer disposed closest to a dam in the non-active area may be adjusted to control the flowability of the second encapsulation layer material, containing an organic material, on the first side surface of the planarization layer, so that the second encapsulation layer may be provided in the non-active area to cover the bank and the planarization layer, even in the case in which the second encapsulation layer material is applied to the surface of a substrate in a smaller amount.
US 2018/151838 A1 relates to an organic light-emitting display device in which the level difference of structures between an active area and an inactive area is reduced by disposing a structure in the inactive area. The structure disposed in the inactive area for providing the even surface in the inactive area may be formed together with the elements in the active area.
US 2021/043715 A1 relates to a display apparatus having improved reliability by arranging a structure for preventing moisture infiltration from the outside to have a constant thickness.

### SUMMARY

An object of the present disclosure is to provide a light emitting display apparatus in which a flow of the protection layer in the edge area can better controlled.

Another object of the present disclosure, not according to the present invention, is to provide a light emitting display apparatus having a thin bezel by minimizing a design margin.

Still another object of the present disclosure, not according to the present invention, is to provide a light emitting display apparatus which improves a display quality by minimizing an electric field interference of electrodes disposed above and below a protection layer by improving a thickness of the protection layer in an outer peripheral area.

Still another object of the present disclosure, not according to the present invention, is to provide a light emitting display apparatus which improves a touch sensitivity in an outer peripheral area of the light emitting display apparatus including a touch line formed on a protection layer by minimizing a step and a curve of an upper surface of the protection layer.

The object is solved by the features of the independent claims. Preferred embodiments are given in the dependent claims.

According to an aspect of the present disclosure, a light emitting display apparatus includes: a substrate including an active area and a non-active area adjacent to the active area; a planarization layer in the active area and a first part of the non-active area; a bank layer, a light emitting diode layer, and a first pattern disposed on the planarization layer; a second pattern and a dam disposed in a second part adjacent to the first part of the non-active area and having different heights.

Objects of the present disclosure are not limited to the above-mentioned objects, and other objects, which are not mentioned above, can be clearly understood by those skilled in the art from the following descriptions.

In one or more embodiments, the planarization layer extends from the active area to the first part of the non-active area.

In one or more embodiments, the second pattern is spaced apart from the first pattern.

In one or more embodiments, the second pattern is spaced apart from the dam.

In one or more embodiments, the second pattern may be disposed between the first pattern and the dam

The light emitting display apparatus further comprises a spacer disposed on a bank.

The first pattern is located on the same layer as the spacer

In one or more embodiments, the spacer may be formed of the same material.

In one or more embodiments, the second pattern may be formed of the same material as the planarization layer.

In one or more embodiments, the light emitting display apparatus may further comprise at least one metal layer disposed above the second pattern.

In one or more embodiments, vertical heights of the first pattern and the second pattern may be lower than a vertical height of the dam.

In one or more embodiments, the dam may include the planarization layer, the bank layer, and the spacer.

In one or more embodiments, the number of each of the first pattern and the second pattern may be two or larger.

In one or more embodiments, the number of dams may be smaller than the number of the first patterns and the second patterns.

In one or more embodiments, the light emitting display apparatus does further comprise a protection layer disposed in the active area and the non-active area.

In one or more embodiments, the protection layer does include a first and a second protection layer.

In one or more embodiments, the second protection layer is formed by an organic material.

In one or more embodiments, at least a part of the second protection layer may be disposed between the second pattern and the dam.

In one or more embodiments, the light emitting display apparatus may further comprise a touch line disposed on the protection layer.

In one or more embodiments, the touch line may be spaced apart from a part of at least one of the first pattern and the dam.

In one or more embodiments, the touch line may overlap at least a part of the second pattern.

In one or more embodiments, the light emitting display apparatus may further comprise a first touch electrode and a second touch electrode disposed in the active area.

In one or more embodiments, the presence of touch and a touch position may be sensed by sensing a variation of a mutual capacitance Cm formed between the first touch electrode and the second touch electrode.

In one or more embodiments, the light emitting display apparatus may further comprise a driving circuit.

In one or more embodiments, the first pattern, the second pattern, and the dam may be disposed between the active area and the driving circuit.

In one or more embodiments, the driving circuit may include at least one of a multiplex MUX, an electrostatic discharge ESD circuit, a high potential voltage line VDD, or a low potential voltage line VSS and the first pattern, the second pattern, and the dam may be disposed between the active area and the multiplexer MUX, the electrostatic discharge ESD circuit, the high potential voltage line VDD, or the low potential voltage line VSS.

In one or more embodiments, the light emitting display apparatus may further comprise a gate driving circuit disposed in the non-active area.

In one or more embodiments, the gate driving circuit may be disposed between the active area and the first pattern, the second pattern, or the dam.

According to the exemplary embodiment of the present disclosure, the light emitting display apparatus configures a first pattern and a second pattern so that the first pattern and the second pattern control a flow of the second protection layer to minimize the overflowing of the second protection layer to an area in which a driving circuit is formed, thereby improving a display quality and a stability.

According to the exemplary embodiment, not according to the present invention, the light emitting display apparatus configures a first pattern and a second pattern so that a design margin is minimized in consideration of an area in which the second protection spreads to provide a thin bezel.

According to the exemplary embodiment of the present disclosure, the light emitting display apparatus configures a first pattern and a second pattern so that a thickness of the protection layer disposed in a non-active area NA adjacent to an active area is improved to efficiently block moisture and oxygen entering from a side surface of the light emitting display apparatus.

According to the exemplary embodiment, not according to the present invention, the light emitting display apparatus configures a first pattern and a second pattern so that a thickness of the protection layer in a non-active area adjacent to an active area is improved to minimize the electric field interference of the electrodes disposed above and below the protection layer, thereby improving a display quality.

According to the exemplary embodiment, not according to the present invention, the light emitting display apparatus minimizes a step and a curve on an upper surface of the protection layer to suppress the loss of the touch line, thereby improving a touch sensitivity of an outer peripheral area of the light emitting display apparatus.

The effects according to the present disclosure are not limited to the contents exemplified above, and more various effects are included in the present specification.

### BRIEF DESCRIPTION OF THE DRAWINGS

The above and other aspects, features and other advantages of the present disclosure will be more clearly understood from the following detailed description taken in conjunction with the accompanying drawings, in which:
FIG. 1 plan view of a light emitting display apparatus of an exemplary embodiment of the disclosure;
FIG. 2 is an enlarged plan view of an outer peripheral area of FIG. 1;
FIG. 3 is a cross-sectional view of a light emitting display apparatus of an exemplary embodiment of the present disclosure;
FIG. 4 is a photomicrograph of a cross-section of a second protection layer of a light emitting display apparatus in which a first pattern and a second pattern of FIG. 3 are formed;
FIG. 5 is a cross-sectional view of a light emitting display apparatus of another exemplary embodiment of the present disclosure;
FIG. 6 is a cross-sectional view of a light emitting display apparatus of another exemplary embodiment of the present disclosure;
FIG. 7 is a plan view of an outer peripheral area of a light emitting display apparatus including a touch sensor layer and a touch line of another exemplary embodiment of the present disclosure; and
FIG. 8 is a cross-sectional view of an outer peripheral area of a light emitting display apparatus including a touch sensor layer and a touch line of another exemplary embodiment of the disclosure.

### DETAILED DESCRIPTION OF THE EMBODIMENT

Advantages and characteristics of the present disclosure and a method of achieving the advantages and characteristics will be clear by referring to exemplary embodiments described below in detail together with the accompanying drawings. However, the present disclosure is not limited to the exemplary embodiments disclosed herein but will be implemented in various forms. The exemplary embodiments are provided by way of example only so that those skilled in the art can fully understand the disclosures of the present disclosure and the scope of the present disclosure. Therefore, the present disclosure will be defined only by the scope of the appended claims.

The shapes, sizes, ratios, angles, numbers, and the like illustrated in the accompanying drawings for describing the exemplary embodiments of the present disclosure are merely examples, and the present disclosure is not limited thereto. Like reference numerals generally denote like elements throughout the specification. Further, in the following description of the present disclosure, a detailed explanation of known related technologies may be omitted to avoid unnecessarily obscuring the subject matter of the present disclosure. The terms such as "including," "having," and "consist of" used herein are generally intended to allow other components to be added unless the terms are used with the term "only". Any references to singular may include plural unless expressly stated otherwise.

Components are interpreted to include an ordinary error range even if not expressly stated.

When the position relation between two parts is described using the terms such as "on", "above", "below", and "next", one or more parts may be positioned between the two parts unless the terms are used with the term "immediately" or "directly". When an element or layer is disposed "on" another element or layer, another layer or another element may be interposed directly on the other element or therebetween.

When the relation of a time sequential order is described using the terms such as "after", "continuously to", "next to", and "before", the order may not be continuous unless the terms are used with the term "immediately" or "directly".

Although the terms "first", "second", and the like are used for describing various components, these components are not confined by these terms. These terms are merely used for distinguishing one component from the other components. Therefore, a first component to be mentioned below may be a second component in a technical concept of the present disclosure.

In describing components of the exemplary embodiment of the present disclosure, terminologies such as first, second, A, B, (a), (b), and the like may be used. The term is used to distinguish a component from the other component but a nature, an order, or the number of the components is not limited by the terminology. When a component is "linked", "coupled", or "connected" to another component, the component may be directly linked or connected to the other component. However, unless specifically stated otherwise, it should be understood that a third component may be interposed between the components which may be indirectly linked or connected.

It should be understood that "at least one" includes one or more all combinations of associated components. For example, "at least one of first, second, and third components" means that not only a first, second, or third component, but also all combinations of two or more of first, second, and third components are included.

In the present disclosure, "apparatus" may include a display apparatus which includes a display panel and a driver for driving the display panel, such as a liquid crystal module (LCM) or an organic light emitting display module (OLED module). Further, the "apparatus" may further include a set electronic device or a set device (or a set apparatus) which is a complete product or a final product including an LCM, or an OLED module, such as a notebook computer, a television, or a computer monitor, an automotive device for vehicle or equipment device including another type of vehicle and a mobile electronic device including a smart phone or an electronic pad.

Accordingly, the apparatus of the present disclosure may include not only a display apparatus itself such as an LCM, or an OLED module, but also an applied product or a set apparatus which is a final consumer device including the LCM, the OLED module, or the like.

In some exemplary embodiments, the LCM or the OLED module configured by the display panel and the driver is represented as a "display apparatus" and an electronic apparatus as a complete product including the LCM or the OLED module is represented as a "set apparatus". For example, the display apparatus may include a liquid crystal LCD or an organic light emitting OLED display panel and a source PCB which is a controller for driving the display panel. The set apparatus may further include a set PCB as a set controller which is electrically connected to the source PCB to drive the entire set apparatus.

As the display panel used in the exemplary embodiment of the present disclosure, any type of display panel such as a liquid crystal display panel, an organic light emitting diode (OLED) display panel, and an electroluminescent display panel may be used, but the exemplary embodiment is not limited thereto. For example, the display panel may be a display panel which is vibrated by a vibrating device of an exemplary embodiment of the present disclosure to generate a sound. The display panel applied to the display apparatus of the exemplary embodiment of the present disclosure is not limited to a shape or a size of the display panel.

The features of various embodiments of the present disclosure can be partially or entirely adhered to or combined with each other and can be interlocked and operated in technically various ways, and the embodiments can be carried out independently of or in association with each other.

Hereinafter, the exemplary embodiment of the present disclosure will be described with reference to the accompanying drawings and examples as follows. Scales of components illustrated in the accompanying drawings are different from the real scales for the convenience of description, so that the scales are not limited to those illustrated in the drawings.

Hereinafter, various exemplary embodiments of the present disclosure will be described in detail with reference to accompanying drawings.

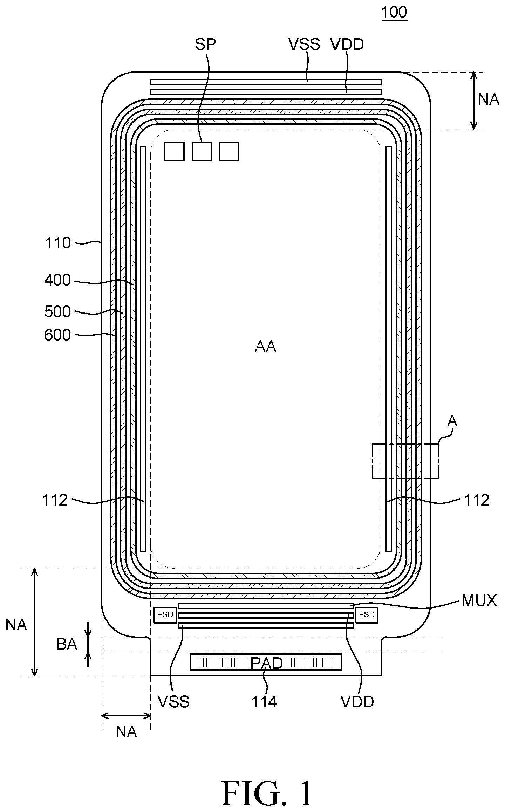

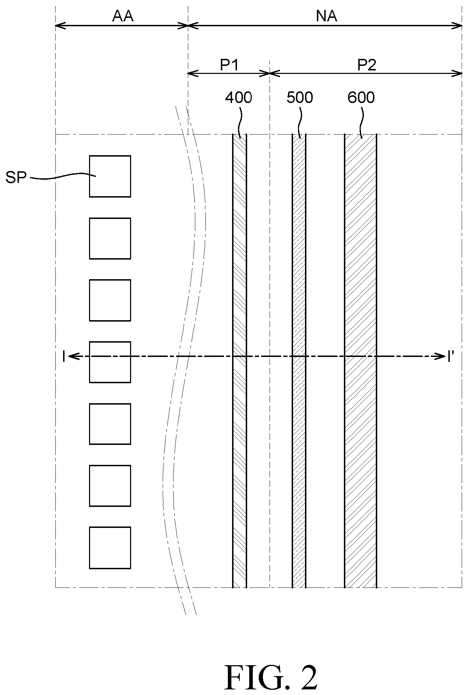

FIG. 1 is a plan view of a light emitting display apparatus of an exemplary embodiment of the present disclosure. FIG. 2 is an enlarged plan view of an outer peripheral area of FIG. 1.

Referring to FIGS. 1 and 2, a light emitting display apparatus 100 of an exemplary embodiment of the present disclosure includes a substrate 110, a first pattern 400, a second pattern 500, and a dam 600.

The light emitting display apparatus 100 may further include various additional elements to generate various signals or drive a plurality of sub pixels SP in an active area AA. For example, one or more driving circuits for controlling the display panel may be included in the light emitting display apparatus. The driving circuit for controlling (or driving) the sub pixels SP includes a gate driver, data signal lines, a multiplex MUX, an electrostatic discharge ESD circuit, a high potential voltage line VDD, a low potential voltage line VSS, an inverter circuit and the like. The light emitting display apparatus 100 may also include an additional element other than a function to drive the sub pixel SP. For example, the light emitting display apparatus 100 may include additional elements which provide a touch sensing function, a user authentication function (for example, fingerprint recognition), a multilevel pressure sensing function, a tactile feedback function, or the like. The above-mentioned additional elements may be located in the non-active area NA or an external circuit which is connected to the connecting interface.

The substrate 110 may include an active area AA and a non-active area NA. The non-active area NA of the substrate may be adjacent to the active area AA and disposed in the outside from the active area AA.

The outer peripheral area A may be an edge area of the substrate 110. For example, the outer peripheral area A may include an end (or one side) of the active area AA and the non-active area NA.

The active area AA is an area where a plurality of sub pixels SP is disposed to display images. Each of the plurality of sub pixels SP is an individual unit which emits light. The plurality of sub pixels SP includes a red sub pixel SP, a green sub pixel SP, a blue sub pixel SP, and/or a white sub pixel SP, but is not limited thereto.

In each of the plurality of sub pixels SP, an organic light emitting diode and a driving circuit for driving the organic light emitting diode are formed. For example, in the plurality of sub pixels SP, a display element for displaying images and a driving circuit for driving (or controlling) the display element may be disposed.

One sub pixel SP may include a plurality of transistors, a capacitor, and a plurality of wiring lines. For example, the sub pixel SP may be configured by two transistors and one capacitor 2T1C, but is not limited thereto so that a sub pixel to which 3T1C, 4T1C, 5T1C, 6T1C, 7T1C, 3T2C, 4T2C, 5T2C, 6T2C, 7T2, or 8T2C is applied may also be implemented.

The non-active area NA is an area where no image is displayed and various wiring lines and driving circuits for driving the plurality of sub pixels SP disposed in the active area AA are disposed. For example, in the non-active area NA, various pads for connecting the sub pixels SP and/or ICs such as a gate driver and a data driver and driving circuits may be disposed. The non-active area NA in which images are not displayed may be an area in which images are not displayed. For example, the non-active area NA may be a bezel area, but is not limited to the terminology.

The non-active area NA may be an area which encloses at least partly or fully the active area AA as illustrated in FIG. 1. The non-active area NA may be an area extending from the active area AA. Alternatively, the non-active area NA may be an area in which a plurality of sub pixels SP is not disposed, but is not limited thereto.

The active area AA may be referred to as an active area and the non-active area NA may be represented as a bezel area, but are not limited to the terminologies.

Even though in FIG. 1, it is illustrated that the non-active area NA encloses a quadrangular active area AA, a shape of the active area AA and a shape and placement of the non-active area NA adjacent to the active area AA are not limited to the example illustrated in FIG. 1. The active area AA and the non-active area NA may have shapes suitable for a design of an electronic device including the light emitting display apparatus 100. In case of a display apparatus which is wearable by a user may have a circular shape such as a normal watch and the concepts of the exemplary embodiments of the present disclosure may also be applied to a free-form display apparatus which is applicable to a vehicle dashboard. For example, an exemplary shape of the active area AA may be a pentagon, a hexagon, an octagon, a circle, or an oval, but is not limited thereto.

A bending area BA may be provided in a part of the non-active area NA. The bending area BA may be provided between the active area AA and a pad unit 114 located in the non-active area NA. Further, the bending area BA may be an area in which a connection line unit is formed.

The bending area BA is an area in which a part of the substrate 110 is bent to dispose the pad unit 114 and an external module bonded to the pad unit 114 on a rear surface of the substrate 110. For example, as the bending area BA is bent toward a rear surface of the substrate 110, the external module bonded to the pad unit 114 of the substrate 110 moves to the rear surface of the substrate 110 so that the external module is not visible as seen from the upper portion of the substrate 110. Further, as the bending area BA is bent, the size of the non-active area NA visible from the upper portion of the substrate 110 is reduced so that a narrow bezel may be implemented. In the present disclosure, it is illustrated that the bending area BA is in the non-active area NA, but is not limited thereto. For example, the bending area BA may be located in the active area AA to bend the active area AA in various directions so that the bending area BA located in the active area AA also has the effect mentioned in the present disclosure.

The pad unit 114 is disposed at one side of the non-active area NA. The pad unit 114 is a metal pattern to which the external module, for example, a flexible printed circuit board FPCB and a chip on film COF are bonded. Even though it is illustrated that the pad unit 114 is disposed at one side of the substrate 110, a shape and a placement of the pad unit 114 are not limited thereto.

The gate driver 112 which supplies the gate signals to the thin film transistors of the sub pixels may be disposed at the other side of the non-active area NA. The gate driver 112 includes various gate driving circuits and the gate driving circuits may be directly formed on the substrate 110. In this case, the gate driver 112 may be a gate-in-panel (GIP).

The gate driver 112 may be disposed between the active area of the substrate 110 and the first pattern 400 disposed in the non-active area NA. Alternatively, the gate driver 112 may be disposed between the active area AA of the substrate 110 and the second pattern 500 disposed in the non-active area NA. Alternatively, the gate driver 112 may be disposed between the active area AA of the substrate 110 and the dam 600 disposed in the non-active area NA.

The high potential voltage line VDD, the low potential voltage line VSS, the multiplexer MUX, the electrostatic discharge ESD circuit, and a plurality of connection line units may be disposed between the active area AA and the pad unit 114 disposed in the non-active area NA.

The high potential voltage line VDD, the low potential voltage line VSS, the multiplexer MUX, and the electrostatic discharge ESD circuit may be disposed between the active area AA and the bending area BA.

The connection line unit may be disposed in the non-active area NA. For example, the connection line unit may be disposed in the bending area BA of the non-active area NA in which the substrate is bent. The connection line unit may be a configuration which transmits a signal (voltage) from the external module bonded to the pad unit 114 to the active area AA or a circuit unit such as the gate driver 112. For example, various signals for driving the gate driver 112, such as a data signal, a high potential voltage, and a low potential voltage, may be transmitted through the connection line unit.

The first pattern 400, the second pattern 500, and the dam 600 may be included in the non-active area NA along the active area AA. The first pattern 400, the second pattern 500, and the dam 600 may be disposed along a periphery of the active area AA so as to control the flow of the second protection layer, among protection layers disposed on the light emitting diode layer.

The first pattern 400, the second pattern 500, and the dam 600 may be disposed between the active area AA and the pad unit 114. The first pattern 400, the second pattern 500, and the dam 600 may be disposed between the active area AA and the bending area BA.

The first pattern 400, the second pattern 500, and the dam 600 may be disposed between the active area AA and the high potential voltage line VDD, the low potential voltage line VSS, the multiplexer MUX, or the electrostatic discharge ESD circuit.

A material which configures the second protection layer 320 is an organic material (polymer) and is applied on the substrate 110 in a liquid state and then hardened to form the second protection layer 320. The organic material has a low viscosity so that it may be in the liquid state having a high density before being hardened. Accordingly, the organic material has a fluidity to flow in an area in which the driving circuit is formed in the non-active area NA of the light emitting display apparatus 100 before being hardened. When the organic material invades the area in which the driving circuit is formed, there may be a problem in that a driving failure or a lighting test failure is caused.

Accordingly, the first pattern 400, the second pattern 500, and the dam 600 may be disposed to be adjacent to the active area AA along the periphery of the active area AA.

Accordingly, before the second protection layer 320 is hardened, the overflowing of the first pattern 400, the second pattern 500, and the dam 600 onto an area where the driving circuit is formed is minimized to suppress the problem of the driving failure and improve the display quality and the stability.

The first pattern 400, the second pattern 500, and the dam 600 are spaced apart from each other having a distance therebetween which is preferably larger than the first pattern 400 or the second pattern 500. The distances between the first pattern 400, the second pattern 500, and the dam 600 may respectively have the width of the dam 600 or somewhat larger.

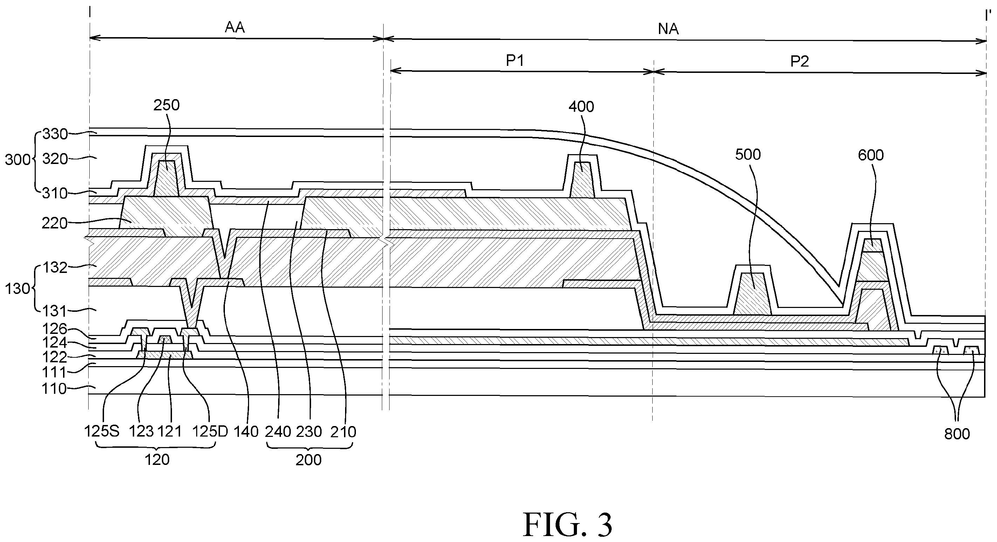

Referring to FIG. 3 to be described below, a crack sensing line 800 may be further included in a part of the non-active area NA of the substrate 110.

The one or more crack sensing lines 800 may be disposed between an end point or edge of the substrate 110 and the dam 600 or the crack sensing line 800 may be disposed below the dam 600 and overlap at least a part of the dam.

The light emitting display apparatus 100 may use a flexible substrate which is formed of a plastic material, for example, polyimide, to implement the small thickness and the flexibility.

The substrate formed of polyimide has a low hardness due to the characteristic of the substrate so that the flexibility may be an advantage, but the crack may be easily generated. For example, a laser trimming process for separating the substrate 110 from a support substrate after finishing a manufacturing process of the light emitting display panel on the support substrate which is formed of glass or the external impacts may easily cause the crack. The crack generated on the substrate 110 or the light emitting display apparatus 100 may be gradually increased as the time elapses. The crack which is generated in a specific area of the substrate 110 or the light emitting display apparatus 100 may become a point in which the stress is concentrated by the force to be applied from the outside thereafter. The stress is concentrated on the crack so that the crack may further extend from the non-active area NA to the active area AA. The external oxygen or moisture may permeate due to the crack. The permeation of oxygen or moisture may oxidize the light emitting diode in the active area AA. The oxidation of the light emitting diode may cause a dark spot or pixel shrinkage in the sub pixel SP. In order to suppress the dark spot or shrinkage of the sub pixel, the crack needs to be managed as a major quality factor. Accordingly, in order to check whether the crack is generated in the light emitting display apparatus 100, the crack sensing line 800 may be further disposed in a part of the non-active area.

Referring to FIG. 2, the non-active area NA may include a first part P1 and a second part P2.

The first part P1 of the non-active area NA may be an area which encloses the active area AA. The first part P1 of the non-active area NA may be a part adjacent to the active area AA in the non-active area NA. The first part P1 of the non-active area NA may be a part disposed between the active area AA and the second part P2 of the non-active area NA. The first part P1 of the non-active area NA may be an area in which a planarization layer 130 is disposed in the non-active area NA.

The second part P2 of the non-active area NA may be an area which encloses the first part P1 of the non-active area NA. The second part P2 of the non-active area NA may be disposed to be adjacent to the first part P1 of the non-active area NA and enclose the first part P1 of the non-active area NA. The second part P2 of the non-active area NA may be an area of the non-active area NA in which the planarization layer 130 is etched to be removed.

The first part P1 of the non-active area NA may extend from the planarization layer 130 disposed in the active area AA. The second part P2 of the non-active area NA may include an end (or one side) of the light emitting display apparatus from an end point (or one side) of the planarization layer 130. So the second part extends between the first part P1 and the edge of the substrate 110.

The first pattern 400 may be disposed in the first part P1 of the non-active area NA. The first pattern 400 may be disposed between the active area AA and the second pattern 500 disposed in the second part P2 of the non-active area NA.

The second pattern 500 may be disposed in the second part P2 of the non-active area NA. The second pattern 500 may be disposed along the periphery of the first pattern 400 and may be disposed between the first pattern 400 and the dam 600.

The dam 600 may be disposed along the periphery of the second pattern 500. The dam 600 may be adjacent to the second pattern 500 and may be disposed at the outside of the first pattern 400 and the second pattern 500.

At least one of each of the first pattern 400, the second pattern 500, and the dam 600 may be disposed. Even though in FIG. 1, one first pattern, one second pattern, and one dam are illustrated, it is not limited thereto.

FIG. 3 is a cross-sectional view of a light emitting display apparatus of an exemplary embodiment of the present disclosure. FIG. 3 is a cross-sectional view taken along the line I-I' of FIG. 2.

Referring to FIG. 3, a light emitting display apparatus 100 of an exemplary embodiment of the present disclosure includes a substrate 110, a planarization layer 130, a light emitting diode layer 200, a first pattern 400, a second pattern 500, and a dam 600.

The substrate 110 may support various components of the light emitting display apparatus. The substrate 110 may be formed of a glass or a plastic material having flexibility.

For example, the substrate 110 may be formed of at least one of polyimide, polyethersulfone, polyethylene terephthalate, and polycarbonate, but is not limited thereto.

When the substrate 110 is formed of a plastic material, for example, when the substrate 110 is formed of polyimide, the manufacturing process of the light emitting display apparatus is performed under a circumstance when a support substrate formed of glass is disposed below the substrate 110. After completing the manufacturing process of the light emitting display apparatus, the support substrate may be released or laser-trimmed. Further, after releasing the support substrate, a back plate which supports the substrate 110 may be disposed below the substrate 110.

When the substrate 110 is formed of polyimide, a moisture component permeates the substrate 110 formed of polyimide so that moisture permeation proceeds to the thin film transistor or the light emitting diode layer to degrade the performance of the light emitting display apparatus. In order to suppress the degradation of the performance of the display apparatus due to the moisture permeation, the display apparatus of the exemplary embodiment of the present disclosure may be configured by two polyimides. Further, an inorganic layer is formed between two polyimides to block the moisture components from permeating the lower polyimide, so that the reliability of the product performance may be improved. The inorganic layer may be formed by a single layer of silicon nitride SiNx or silicon oxide SiOx or a multi-layer thereof, but is not limited thereto.

The substrate 110 is referred to as a concept including elements and functional layers formed on the substrate 110, such as a switching element, a driving element (or thin film transistor) connected to the switching element, an organic light emitting diode connected to the driving element (or thin film transistor), and a protection layer. However, it is not limited thereto.

The buffer layer 111 may be disposed on the entire surface of the substrate 110. The buffer layer 111 may improve the adhesiveness between layers formed on the buffer layer and the substrate and block various types of defects such as alkali components leaked from the substrate 110. Further, the buffer layer 111 may delay the diffusion of moisture or oxygen which permeates the substrate 110.

The buffer layer 111 may be formed by a single layer of silicon nitride SiNx or silicon oxide Si-Ox or a multi-layer thereof. When the buffer layer 111 is formed of a multi-layer, silicon oxide SiOx and silicon nitride SiNx are alternately formed.

The buffer layer 111 may be omitted based on a type and a material of the substrate 110 and a structure and a type of the thin film transistor.

In the light emitting display apparatus of the exemplary embodiment of the present disclosure, the thin film transistor 120 may be further disposed on the buffer layer 111. The thin film transistor 120 may include a semiconductor pattern 121, a gate electrode 123, a source electrode 125S, and a drain electrode 125D.

The drain electrode 125D is electrically connected to the light emitting diode layer 200 to transmit a current or a signal to the light emitting diode layer 200. Further, a connection electrode 140 is further disposed between the drain electrode 125D and the light emitting diode layer 200 to transmit the current and the signal of the thin film transistor to the light emitting diode layer 200 via the connection electrode 140.

Even though only a driving thin film transistor is illustrated among various thin film transistors which may be included in the light emitting display apparatus 100 for the convenience of description, another thin film transistor such as a switching thin film transistor may also be included in the light emitting display apparatus 100. For the convenience of description, even though it is described that the thin film transistor 120 has a top gate structure, it is not limited to this structure so that the thin film transistor may be implemented by another structure such as a bottom gate structure.

The semiconductor pattern 121 may be disposed on the buffer layer 111. The semiconductor pattern 121 may be formed of a polycrystalline semiconductor. For example, the polycrystalline semiconductor may be formed of a low temperature poly silicon LTPS having a high mobility, but is not limited thereto. When the semiconductor pattern 121 is formed of a polycrystalline semiconductor, the energy consumption is low and the reliability is excellent.

Further, the semiconductor pattern 121 may be formed of an oxide semiconductor. For example, the semiconductor pattern may be formed of any one of indium gallium zinc oxide IGZO, indium zinc oxide IZO, indium gallium tin oxide IGTO, and indium gallium oxide IGO, but is not limited thereto. When the semiconductor pattern 121 is formed of an oxide semiconductor, it has an excellent effect to block the leakage current so that the luminance variation of the sub pixel during the low speed driving may be minimized.

When the semiconductor pattern 121 is formed of the polycrystalline semiconductor or the oxide semiconductor, a partial area of the semiconductor pattern 121 may be doped with impurities.

Further, the semiconductor pattern 121 may be made of amorphous silicon a-Si or various organic semiconductor materials such as pentacene, but is not limited thereto.

The first insulating layer 122 may be disposed on the semiconductor pattern 121. The first insulating layer 122 may insulate the gate electrode 123 from the semiconductor pattern 121.

The first insulating layer 122 may be formed of an inorganic insulating material such as silicon nitride SiNx or silicon oxide SiOx, or other insulating organic material, but is not limited thereto.

The first insulating layer 122 may include a hole to electrically connect the source electrode 125S and the drain electrode 125D to the semiconductor pattern 121, respectively.

The gate electrode 123 may be disposed on the first insulating layer 122. The gate electrode 123 may be disposed so as to overlap the semiconductor pattern 121.

The gate electrode 123 may be formed of a single layer or a multi-layer formed of any one of molybdenum (Mo), copper (Cu), titanium (Ti), aluminum (Al), chrome (Cr), gold (Au), nickel (Ni), neodymium (Nd), tungsten (W), and gold (Au) or an alloy thereof, but is not limited thereto.

A second insulating layer 124 may be disposed on the gate electrode 123.

The second insulating layer 124 may be formed of an insulating material such as silicon nitride SiNx or silicon oxide SiOx or other insulating organic material, but is not limited thereto.

The second insulating layer 124 may include a hole to electrically connect the source electrode 125S and the drain electrode 125D to the semiconductor pattern 121, respectively.

The source electrode 125S and the drain electrode 125D may be disposed on the second insulating layer 124.

The source electrode 125S and the drain electrode 125D may be formed of a single layer or a multi-layer formed of any one of molybdenum (Mo), copper (Cu), titanium (Ti), aluminum (Al), chrome (Cr), gold (Au), nickel (Ni), and neodymium (Nd) or an alloy thereof, but is not limited thereto.

For example, the source electrode 125S and the drain electrode 125D may be formed by a triple-layered structure of titanium (Ti)/aluminum (Al)/titanium (Ti) formed of a conductive metal material.

The source electrode 125S and the drain electrode 125D are electrically connected to the semiconductor pattern 121 through the holes of the first insulating layer 122 and the second insulating layer 124.

A protection layer 126 may be disposed above the thin film transistor 120. The protection layer 126 may be disposed in the active area AA and a part of the non-active area NA (above the hashed layer being the metal layer of the source and drain electrode).

The protection layer 126 may protect the thin film transistor 120. The protection layer 126 may be formed of an inorganic insulating material such as silicon nitride SiNx or silicon oxide SiOx, or other insulating organic material, but is not limited thereto.

The protection layer 126 may include a hole to electrically connect the thin film transistor 120 to the connection electrode 140 or the light emitting diode layer 200. The protection layer 126 is not an essential component, so that it may be omitted depending on the design of the light emitting display apparatus 100.

The planarization layer 130 may be disposed on the protection layer 126. The planarization layer 130 may be disposed to cover the thin film transistor 120.

The planarization layer 130 may protect the thin film transistor disposed therebelow and relieve or planarize a step due to various patterns.

The planarization layer 130 may be formed of at least one material among organic insulating materials, such as benzocyclobutene BCB, acrylic resin, epoxy resin, phenolic resin, polyamide resin, or polyimide resin, but is not limited thereto. The planarization layer 130 may be disposed as a single layer, but may be disposed as two or more layers in consideration of the placement of the electrode.

This is because as the light emitting display apparatus 100 evolves to have a higher resolution, various signal lines are required and thus the number of lines is increased. Therefore, it is difficult to dispose all the wiring lines on one layer while ensuring a minimum interval so that an additional layer is provided. There is a margin in the placement of the wiring line by providing such an additional layer, which makes it easier to design the electric wire/electrode placement. Further, when a dielectric material is used for the planarization layer configured by a multi-layer, the planarization layer 130 may be utilized to form a capacitance between metal layers.

When two planarization layers 130 are provided, the planarization layers may include a first planarization layer 131 and a second planarization layer 132.

The connection electrode 140 may be disposed between the first planarization layer 131 and the second planarization layer 132.

A hole is formed in the first planarization layer 131 and the connection electrode 140 is formed in the hole so that the thin film transistor 120 and the light emitting diode layer 200 may be electrically connected to each other by means of the connection electrode 140.

For example, one end (or a part) of the connection electrode 140 may be connected to the thin film transistor 120 and the other end (or the other part) of the connection electrode 140 may be connected to the light emitting diode layer 200.

The planarization layer 130 may be disposed in the active area AA and a part of the non-active area NA. For example, the planarization layer 130 may extend from the active area to the first part P1 of the non-active area.

The planarization layer 130 is etched in the non-active area NA to form a step.

In the non-active area NA, a part of the planarization layer 130 which is not removed by the etching process may be the first part P1. A part of the planarization layer 130 which is removed by the etching process may be the second part P2.

The light emitting diode layer 200 may be disposed on the planarization layer 130. The light emitting diode layer 200 may include an anode electrode 210, an emission layer 230, and a cathode electrode 240.

The light emitting diode layer 200 may be formed by sequentially disposing the anode electrode 210, the emission layer 230, and the cathode electrode 240 on the planarization layer 130.

The anode electrode 210 may be disposed on the planarization layer 130.

The anode electrode 210 may be electrically connected to the drain electrode 125D through the hole of the planarization layer 130. Alternatively, when the light emitting display apparatus 100 further includes the connection electrode 140, the anode electrode 210 may be electrically connected to the drain electrode 125D by means of the connection electrode 140.

The anode electrode 210 may supply holes to the emission layer 230 and may be formed of a conductive material having a high work function.

When the light emitting display apparatus 100 is a top emission type, the anode electrode 210 may be disposed using an opaque conductive material as a reflective electrode which reflects light. The anode electrode 210 may be formed of at least one of silver (Ag), aluminum (Al), gold (Au), molybdenum (Mo), tungsten (W), chrome (Cr), or an alloy thereof. For example, the anode electrode 210 may be formed with a triple layered structure of silver (Ag)/lead (Pb)/copper (Cu), but is not limited thereto.

When the light emitting display apparatus 100 is a bottom emission type, the anode electrode 210 may be disposed using a transparent conductive material through which light passes. For example, the anode electrode 210 may be formed of at least one of indium tin oxide ITO and indium zinc oxide IZO.

A bank layer 220 may be disposed on the planarization layer 130 or the anode electrode 210 in the active area AA and the non-active area NA.

The bank layer 220 may divide the plurality of sub pixels SP, minimize the glaring phenomenon, and suppress color mixture at various viewing angles.

The bank layer 220 may be disposed on the planarization layer 130 or the anode electrode 210 in the remaining area excluding the emission area. The bank layer 220 may have a bank hole which exposes the anode electrode 210 corresponding to the emission area.

The bank layer 220 may be formed of at least one material among inorganic insulating materials, such as silicon nitride SiNx or silicon oxide SiOx or organic insulating materials, such as benzocyclobutene BCB, acrylic resin, epoxy resin, phenolic resin, polyamide resin, or polyimide resin, but is not limited thereto.

A spacer 250 may be further disposed on the bank layer 220. The spacer 250 may minimize the light emitting display apparatus 100 from being broken due to the external impact by buffering an empty space between the substrate 110 on which the light emitting diode layer 200 is formed and the upper substrate. The spacer 250 may be formed of the same material as the bank layer 220 and simultaneously formed with the bank layer 220, but is not limited thereto.

The first pattern 400, the second pattern 500, and the dam 600 may be disposed in the non-active area NA of the light emitting display apparatus 100. The first pattern 400, the second pattern 500, and the dam 600 may suppress the problems such as a driving failure caused when the second protection layer 320 of the protection layer 300 invades an area of the non-active area NA in which the driving circuit is formed.

At least one of each of the first pattern 400, the second pattern 500, and the dam 600 may be formed. In order to implement a thin bezel by minimizing the design margin of the second protection layer while suppressing the overflowing of the second protection layer 320 to the driving element, the number of first patterns 400 and second patterns 500 may be at least two, and the number of dams 600 may be at least one.

A material which configures the second protection layer 320 is an organic material (polymer) and is applied on the substrate 110 in a liquid state and then hardened to form the second protection layer 320. The organic material has a low viscosity so that it may be in the liquid state having a high density before being hardened. Accordingly, the organic material has a fluidity to flow in an area in which the driving circuit is formed in the non-active area of the light emitting display apparatus 100 before being hardened. When the organic material invades the area in which the driving circuit is formed, there may be a problem in that a driving failure or a lighting test failure is caused.

Therefore, the inventors of the present disclosure conducted several experiments to reduce or prevent or stop the flow of the organic material at predetermined locations until the second protection layer 320 was hardened. The inventors invented a light emitting display apparatus 100 which minimized the flow of the organic material of the second protection layer 320 of the light emitting display apparatus and minimized the driving failure caused by the invasion of the second protection layer 320 in an area of the non-active area NA in which the driving circuit was formed, through several experiments.

The first pattern 400, the second pattern 500, and the dam 600 may control the flowability of the organic material of the second protection layer 320. First, the flow of the organic material of the second protection layer 320 is controlled by the first pattern 400 adjacent to the active area AA. When the organic material overflows the first pattern 400, flow of the organic material may be controlled by the second pattern 500 which is secondarily disposed. The second pattern 500 does not allow the organic material to overflow the dam 600.

The dam 600 which is higher than the second pattern 500 is disposed at the outer edge of the second pattern 500 to confine the organic material in the dam 600 so that the spreading (or flowing) of the organic material of the second protection layer 320 into the driving circuit in the non-active area may be blocked by the dam 600 thirdly disposed.

The first pattern 400 may be disposed along the periphery of the active area AA. For example, the first pattern 400 may be adjacent to the active area AA to enclose the active area AA.

The first pattern 400 may be disposed in the first part P1 of the non-active area NA. For example, the first pattern 400 is disposed on the planarization layer 130 of the non-active area NA which extends from the active area AA.

Since the first pattern 400 is disposed on the planarization layer 130 of the first part P1, the first pattern 400 is disposed in a higher position than the second pattern 500 and the dam 600 and is formed to be more adjacent to the active area AA to more efficiently control the flow of the organic material before the second protection layer 320 is primarily hardened.

Since the first pattern 400 is disposed on the planarization layer 130, the flow of the organic material of the protection layer 320 in the first pattern 400 disposed in the non-active area NA adjacent to the active area AA is blocked so that the thickness of the protection layer 320 may be increased after being hardened. The protection layer 300 having an increased thickness may efficiently block moisture and oxygen flowing from a side surface of the light emitting display apparatus 100.

The first pattern 400 may be disposed in the first part P1 of the non-active area NA while enclosing the periphery of the active area AA. The first pattern 400 may be disposed to be spaced apart from at least a part of the active area AA.

The first pattern 400 may be disposed as a single layer or a plurality of layers using at least one material. The first pattern 400 may be formed of the same material as the spacer 250 of the active area AA and may be simultaneously formed with the spacer 250, but is not limited thereto.

The second pattern 500 may be disposed in the second part P2 of the non-active area NA so as to enclosure the periphery of the first pattern 400 of the non-active area NA. The second pattern 500 may be disposed to be at least partially spaced apart from the first pattern 400.

The second pattern 500 blocks the flowing of the organic material which is spread (or flew) from the first pattern 400 to reduce the moving speed of the organic material.

The second pattern 500 may be disposed as a plurality of layers using at least one material. The second pattern 500 may be formed of the same material as the spacer 250 of the active area AA and may be simultaneously formed with the spacer 250, but is not limited thereto.

Even though the dam 600 is disposed in the second part P2 of the non-active area NA, a moving speed of the organic material of the second protection layer 320 is increased due to a height and a slope of a step formed by etching a plurality of planarization layers, insulating layers, and metal lines in the non-active area NA. Therefore, there is a problem in that the second protection layer 320 spreads (or flows) to the driving circuit of the non-active area NA before being hardened.

However, the second pattern 500 is disposed in the second part P2 of the non-active area NA, that is, between the first pattern 400 and the dam 600 to suppress or reduce the flow of the organic material of the second protection layer 320. Accordingly, the second pattern 500 reduces a spreading (or flowing) speed of the organic material of the second protection layer 320 to control a spreading (or flowing) distance of the second protection layer 320. Therefore, the problem such as the driving failure which is caused by the second protection layer 320 which invades the non-active area NA may be suppressed.

Further, the spreading (or flowing) distance of the second protection layer 320 is minimized to minimize a design margin of the second protection layer 320 so that a light emitting display apparatus which has a thin bezel and has an improved reliability may be provided.

The dam 600 may be disposed in the second part P2 of the non-active area NA so as to enclose the periphery of the second pattern 500. The dam 600 may be disposed to be at least partially spaced apart from the second pattern 500.

For example, the dam 600 may be disposed on the second part P2 which is an area in which the planarization layer 130 of the non-active area NA is etched to be removed. At least one or a plurality of dams 600 may be disposed. Even though in FIG. 1, one dam is illustrated, it is not limited thereto.

The dam 600 may be disposed as a multi-layer using at least one material.

The dam 600 may be formed as at least one layer using at least one material. For example, the dam may include at least one material among the materials used to dispose the planarization layer 130, the bank layer 220 and the spacer 250.

The dam 600 may be sequentially laminated in the non-active area NA to be formed as a multi-layer when the planarization layer 130, the bank layer 220, and the spacer 250 disposed in the active area AA are formed, but is not limited thereto.

The dam 600 may include the same material as the anode electrode 210 disposed in the active area AA.

The emission layer 230 may be disposed on the anode electrode 210. The emission layer 230 may be a layer configured by an organic material which emits light with a specific color. For example, the emission layer 230 may be configured by at least one of a red organic emission layer, a green organic emission layer, a blue organic emission layer, and a white organic emission layer. When the emission layer 230 is configured by the white organic emission layer, a color filter may be further disposed above the light emitting diode layer 200.

In addition to the emission layer 230, a hole injection layer, a hole transport layer, an electron transport layer, and an electron injection layer may be included, but is not limited thereto.

The cathode electrode 240 may be disposed on the emission layer 230. The cathode electrode 240 supplies electrons to the emission layer 230 and may be formed of a conductive material having a low work function.

When the light emitting display apparatus 100 is a top emission type, the cathode electrode 240 may be disposed using a transparent conductive material through which light passes. For example, the cathode electrode may be formed of at least one of indium tin oxide ITO and indium zinc oxide IZO, but is not limited thereto.

Further, the cathode electrode may be disposed using a translucent conductive material through which light passes. For example, the cathode electrode may be formed of at least one of alloys such as LiF/Al, CsF/Al, Mg:Ag, Ca/Ag, Ca:Ag, LiF/Mg:Ag, LiF/Ca/Ag, and LiF/Ca:Ag.

When the light emitting display apparatus 100 is a bottom emission type, the cathode electrode 240 may be disposed using an opaque conductive material as a reflective electrode which reflects light. For example, the cathode electrode 240 may be formed of at least one of silver (Ag), aluminum (Al), gold (Au), molybdenum (Mo), tungsten (W), chrome (Cr), or an alloy thereof.

The protection layer 300 may be disposed on the light emitting diode layer 200. The protection layer 300 may be disposed in the active area AA and the non-active area NA of the light emitting display apparatus 100.

The protection layer 300 suppresses the permeation of the oxygen and moisture from the outside to suppress the oxidation of a light emitting material and an electrode material. The protection layer 300 may include a first protection layer 310, a second protection layer 320, and a third protection layer 330 which block the permeation of moisture or oxygen.

The first protection layer 310, the second protection layer 320, and the third protection layer 330 may be alternately laminated. The protection layer 300 may be formed of a transparent material to transmit light emitted from the emission layer 230.

The first protection layer 310 and the third protection layer 330 may be formed at the outer edge of the dam 600 disposed in the non-active area NA. For example, the first protection layer 310 and the third protection layer 330 may be disposed between the dam 600 and the edge (or one side) of the substrate. The first protection layer 310 and the third protection layer 330 may be disposed directly on the dam 600.

The second protection layer 320 may be formed until or inside the area surrounded by the dam 600 disposed in the non-active area NA. For example, the second protection layer 320 may be disposed between the dam 600 and the active area AA. Alternatively, the second protection layer 320 may be disposed between the dam 600 and the second pattern 500.

The first protection layer 310 and the third protection layer 330 may be formed of at least one inorganic material among silicon nitride SiNx, silicon oxide SiOx, and aluminum oxide AlyOz. The first protection layer 310 and the third protection layer 330 may be formed using a vacuum film forming method such as chemical vapor deposition (CVD) or atomic layer deposition (ALD), but are not limited thereto.

The second protection layer 320 may cover foreign materials or particles which may be generated during a manufacturing process. Further, the second protection layer 320 may planarize a surface of the first protection layer 310. For example, the second protection layer 320 may be a particle cover layer, but is not limited to the terminology.

The second protection layer 320 may be an organic material, for example, a polymer such as silicon oxy carbon SiOCz, epoxy, polyimide, polyethylene, or acrylate. For example, the second protection layer 320 may be a polymer having a viscosity of 20 or lower, but is not limited thereto.

The second protection layer 320 may be formed of a thermosetting material or a photo curable material which is hardened by heat or light.

The second protection layer 320 may be formed by various methods such as inkjet coating or slit coating. For example, the second protection layer 320 may be formed on the first protection layer 310 by spraying or dropping a liquid organic material on the first substrate 110 on which the first protection layer 310 is formed, in the active area AA using an inkjet device or a nozzle coating device. A fluid organic material may be formed in an applying area while the spraying nozzle moves on the applying area (or a nozzle is fixed and a subject moves).

After spraying or dropping the organic material, a solvent and moisture are removed by performing a drying process and a hardening process on the organic material to form a hardened second protection layer 320.

When the liquid organic material is sprayed or dropped on the first substrate 110 in the active area AA, the first pattern 400 formed in the first part P1 and the second pattern 500 formed in the second part P2 of the non-active area AA which encloses the active area AA may effectively block the flow of the organic material.

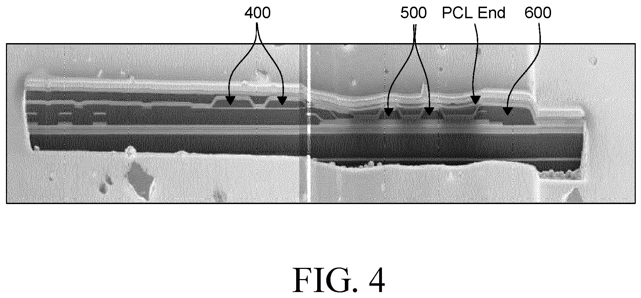

FIG. 4 is a photomicrograph of a cross-section of a second protection layer according to a light emitting display apparatus in which a first pattern and a second pattern of FIG. 3 are formed.

An arrow of FIG. 4 indicates an end point of the second protection layer 320.

The second protection layer 320 illustrated in FIG. 4 is formed after curing the organic material which configures the second protection layer. It is confirmed that the end point (PCL end) of the second protection layer 320 is formed by passing through the first pattern 400 and the second pattern 500, without passing over the dam 600.

A material which configures the second protection layer 320 has a low viscosity characteristic so that it may be in a liquid state having a high density until the material is hardened. Referring to FIG. 4, the first pattern 400 is primarily disposed to be adjacent to the active area AA to enclose the active area and then the second pattern 500 is secondarily disposed to enclose the first pattern 400. Therefore, it is confirmed that before curing the second protection layer 320, the moving speed of the organic material becomes slow by the first pattern 400 and the second pattern 500 to minimize an amount of the organic material of the second protection layer 320 which overflows the dam 600 to spread (or flow) into the non-active area NA.

Further, when the first pattern 400 and the second pattern 500 are not disposed, the significant distance from the active area AA to the dam 600 is set as the design margin of the second protection layer 320. Further, the spreading (or flowing) distance of the second protection layer 320 onto the first pattern 400 and the second pattern 500 which are configured to be smaller than the width or the height of the dam 600 is minimized to minimize the design margin of the second protection layer 320. By doing this, a light emitting display apparatus with a thin bezel and an improved reliability may be provided. In the present disclosure, "height" may refer to a height from the bottom of a pattern or a dam to the top of said pattern or said dam in a cross sectional view.

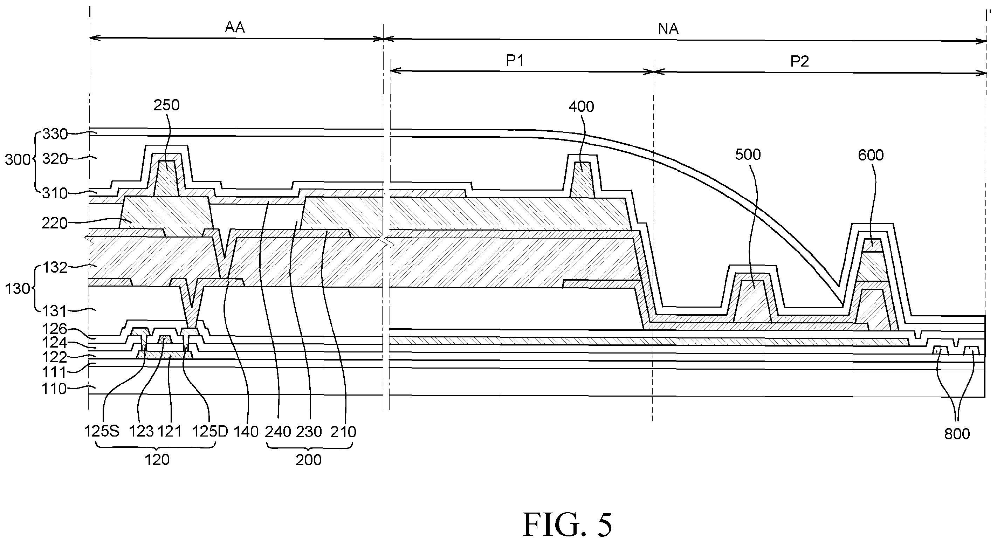

Hereinafter, another exemplary embodiment of the present disclosure will be described with reference to FIG. 5.

A light emitting display apparatus 100 of FIG. 5 is substantially the same as the display apparatus of FIG. 3 except for a second pattern 500 so that a redundant description will be omitted or will be briefly provided.

FIG. 5 is a cross-sectional view of a light emitting display apparatus of another exemplary embodiment of the present disclosure.

Referring to FIG. 5, a light emitting display apparatus 100 of another exemplary embodiment of the present disclosure includes a substrate 110 which includes an active area AA and a non-active area NA, a planarization layer 130, a protection layer 300, a first pattern 400, a second pattern 500, and a dam 600.

The second pattern 500 may be disposed as a multi-layer using at least one material. The second pattern 500 may be formed of the same material as the planarization layer 130 of the active area AA and may be simultaneously formed with the planarization layer 130, but is not limited thereto.

When two planarization layers 130 are provided, the planarization layers may include a first planarization layer 131 and a second planarization layer 132.

Therefore, the second pattern 500 may be formed of the same material as the first planarization layer 131 or the second planarization layer 132 and simultaneously formed with the first planarization layer 131 or the second planarization layer 132, but is not limited thereto.

The second pattern 500 may be disposed as a single layer of the first planarization layer 131 or the second planarization layer 132 or may be disposed as a double layer of the first planarization layer 131 and the second planarization layer 132.

When the second pattern 500 is formed simultaneously with the planarization layer 130 disposed in the active area AA, the same material as the anode electrode 210 disposed in the active area AA on the second pattern 500 or a material used for the process may be further disposed.

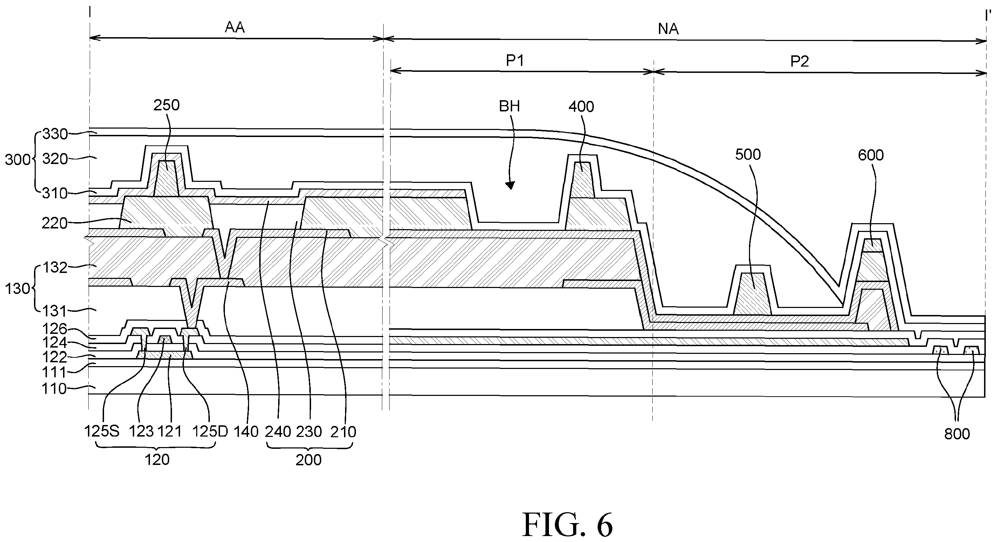

Hereinafter, another exemplary embodiment of the present disclosure will be described with reference to FIG. 6.

A light emitting display apparatus 100 of FIG. 6 is substantially the same as the display apparatus of FIG. 3 except for a buffer hole BH so that a redundant description will be omitted or will be briefly provided.

FIG. 6 is a cross-sectional view of a light emitting display apparatus of another exemplary embodiment of the present disclosure.

Referring to FIG. 6, a light emitting display apparatus 100 of another exemplary embodiment of the present disclosure includes a substrate 110 which includes an active area AA and a non-active area NA, a planarization layer 130, a protection layer 300, a first pattern 400, a second pattern 500, a dam 600, and a buffer hole BH.

The buffer hole BH may be disposed on the planarization layer 130 or the anode electrode 210 in the first part P1 of the non-active area NA.

The buffer hole BH may be disposed along the periphery of the active area AA. For example, the buffer hole BH may be disposed between the active area AA and the first pattern 400. The buffer hole BH may be a hole or a first hole, but is not limited to the terminology.

The buffer hole BH may be formed by the same process as the bank hole of the active area AA, but is not limited thereto.

At least one buffer hole BH may be disposed. For example, the buffer hole BH is formed by etching the bank layer 220 to suppress the overflowing of the organic material of the second protection layer 320 beyond the first pattern 400. For example, the buffer hole BH is configured so that an amount of the organic material of the second protection layer 320 overflowing the first pattern 400 is reduced and a spreading (or flowing) distance of the organic material of the second protection layer 320 may be further effectively controlled. Accordingly, the buffer hole BH is configured so that the problem such as the driving failure which is caused by the second protection layer 320 which invades the non-active area NA may be suppressed. Further, a buffer space may be ensured in consideration of a deviation of an applied amount of the second protection layer 320 so that a light emitting display apparatus which has a thin bezel may be provided by minimizing a design margin of the second protection layer 320.

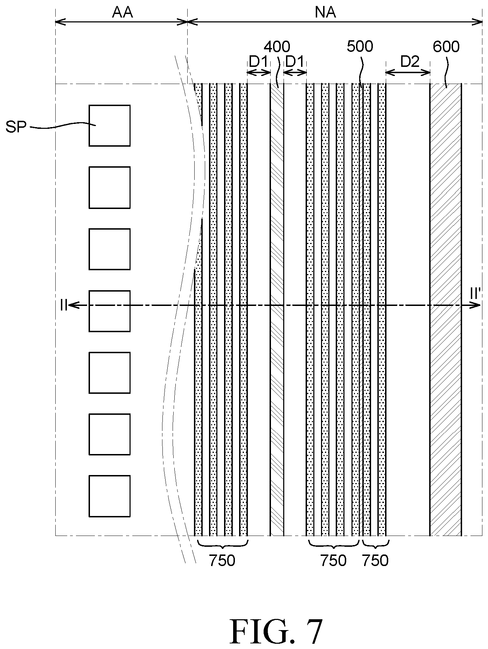

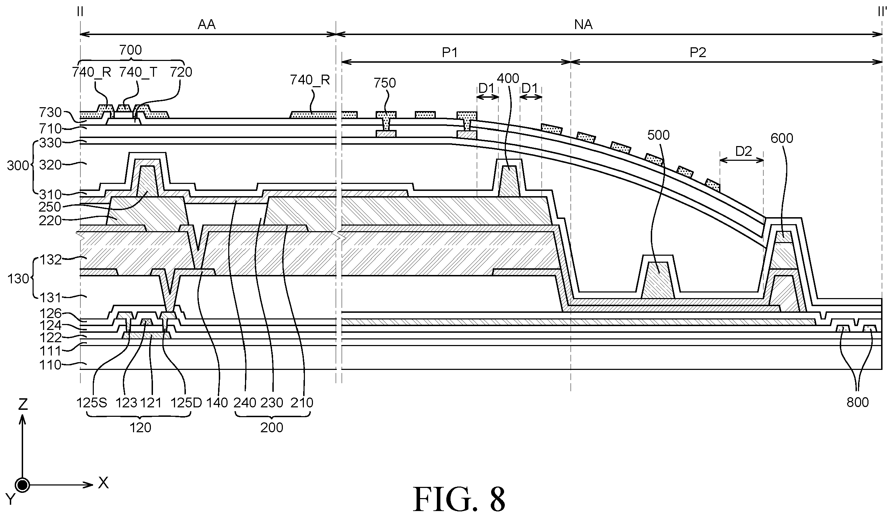

Hereinafter, another exemplary embodiment of the present disclosure will be described with reference to FIGS. 7 and 8.

A light emitting display apparatus 100 of FIGS. 7 and 8 is substantially the same as the light emitting display apparatus of FIG. 3 except for a touch sensor layer 700 and a touch line 750 so that a redundant description will be omitted or will be briefly provided.

FIG. 7 is a plan view of an outer peripheral area of a light emitting display apparatus including a touch sensor layer and a touch line of another exemplary embodiment of the present disclosure. FIG. 8 is a cross-sectional view of an outer peripheral area of a light emitting display apparatus including a touch sensor layer and a touch line of another exemplary embodiment of the present disclosure.

Referring to FIGS. 7 and 8, a touch sensor layer 700 and a touch line 750 may be disposed on the protection layer 300.

The touch sensor layer 700 may be disposed in the active area AA. The touch sensor layer 700 may include a first touch electrode 740_R, a second touch electrode 740_T, a first touch connection electrode 720, and a second touch connection electrode.

The first touch electrode 740_R, the second touch electrode 740_T, the first touch connection electrode 720, and the second touch connection electrode disposed in the active area AA may be formed with a mesh pattern in which metal lines having a small line width intersect each other. The mesh pattern may have a rhombus shape and a shape of the mesh pattern may be a rectangle, a pentagon, a hexagon shape, a circle, or an oval, but is not limited thereto.

The first touch electrode 740_R, the second touch electrode 740_T, the first touch connection electrode 720, and the second touch connection electrode may be disposed using an opaque conductive material having a low resistance. For example, the first touch electrode 740_R, the second touch electrode 740_T, the first touch connection electrode 720, and the second touch connection electrode may have a single layer or a multiple-layered structure formed of a metal material such as molybdenum (Mo), silver (Ag), titanium (Ti), copper (Cu), aluminum (Al), titanium/aluminum/titanium (Ti/Al/Ti), and molybdenum/aluminum/molybdenum (Mo/Al/Mo). However, it is not limited thereto.

An opening may be formed in the mesh pattern of the first touch electrode 740_R and the second touch electrode 740_T. The opening may correspond to the sub pixel SP. For example, the light emitting diode layer 200 may be disposed in the opening.

The first touch electrode 740_R, the second touch electrode 740_T, the first touch connection electrode 720, and the second touch connection electrode do not overlap red (R), green (G), and blue (B) light emission areas, but overlap the bank layer 220 formed in the non-emission area. Therefore, even though the electrodes are formed of the opaque conductive material, the degradation of the aperture and the transmittance may be suppressed.

A first touch block Rx configured by at least one first touch electrode 740_R and a first touch connection electrode 720 which connects the plurality of first touch electrodes 740_R may be included. At least one first touch block Rx extends along the first direction (or an X-axis direction). The plurality of first touch blocks Rx may be disposed with a predetermined interval.

A second touch block Tx configured by at least one second touch electrode 740_T and a second touch connection electrode which connects the plurality of second touch electrodes 740_T may be included. At least one second touch block Tx extends along the second direction (or a Y-axis direction). The plurality of second touch blocks Tx may be disposed with a predetermined interval.

The first touch block Rx and the second touch block Tx may be disposed to be spaced apart from each other with a predetermined interval. Therefore, the first touch block Rx and the second touch block Tx may be electrically isolated.

The first touch block Rx and the second touch block Tx are connected to the touch driver by means of the touch line 750 to transmit or receive signals. For example, the touch driver may receive a touch sensing signal from the first touch block Rx or the first touch electrode 740_R. Further, the touch driver may transmit a touch driving signal to the second touch block Tx or the second touch electrode 740_T. The touch driver may sense the touch of the user using a mutual capacitance between the first touch block Rx or the plurality of first touch electrodes 440_R and the second touch block Tx or the plurality of second touch electrodes 440_T. For example, when the touch operation is performed in the light emitting display apparatus 100, the capacitance change may be caused between the first touch block Rx or the first touch electrodes 740_R and the second touch block Tx or the second touch electrodes 740_T. The touch driver may sense the capacitance change to detect a touch coordinate.

A touch buffer layer 710 may be disposed on the protection layer 300. The touch buffer layer 710 may block a liquid chemical (developer or etchant) used during the process of manufacturing a touch sensor layer 700 or moisture from the outside from being permeated into the light emitting diode layer 200 including an organic material. Further, the touch buffer layer 710 may suppress the disconnection of the plurality of touch electrodes disposed thereabove due to the external impact.

The touch buffer layer 710 may be formed of a single layer or a multi-layer formed of any one of silicon oxide SiOx or silicon nitride SiNx or an alloy thereof, but is not limited thereto. Alternatively, the touch buffer layer 710 may be formed of an acryl resin, epoxy resin, or siloxane-based material, but is not limited thereto.

The first touch connection electrode 720 may be disposed in the active area AA on the touch buffer layer 710.

The first touch connection electrode 720 disposed in the active area AA may be disposed between the first touch electrodes 740_R adjacent in the first direction (or the X-axis direction). The first touch connection electrode 720 may electrically connect the plurality of first touch electrodes 740_R which is spaced apart in the first direction (or the X-axis direction) to be adjacent.

The first touch connection electrode 720 may be disposed so as to overlap the second touch connection electrode which connects the second touch electrodes 740_T adjacent in the second direction (or the Y-axis direction). The first touch connection electrode 720 and the second touch connection electrode are formed on different layers to be electrically insulated.

A touch insulating layer 730 may be disposed on the touch buffer layer 710 and the first touch connection electrode 720. The touch insulating layer 730 may be formed in the active area AA and the non-active area NA.

The touch insulating layer 730 may electrically insulate the first touch connection electrode 720 from the second touch electrode 740_T and the second touch connection electrode.

The touch insulating layer 730 may include a hole to electrically connect the first touch electrode 740_R and the first touch connection electrode 720.

The touch insulating layer 730 may be formed by a single layer of silicon nitride SiNx or silicon oxide SiOx or a multi-layer thereof, but is not limited thereto.

The first touch electrode 740_R, the second touch electrode 740_T, and the second touch connection electrode may be disposed on the touch insulating layer 730 in the active area AA.

The first touch electrode 740_R and the second touch electrode 740_T may be disposed to be spaced apart from each other with a predetermined interval. At least one first touch electrode 740_R adjacent in the first direction (or the X-axis direction) may be formed to be spaced apart from each other. At least one first touch electrode 740_R adjacent to each other in the first direction (or the X-axis direction) may be connected to the first touch connection electrode 720 disposed between the first touch electrodes 740_R, respectively. For example, each of the first touch electrodes 740_R may be connected to the first touch connection electrodes 720 by means of the hole of the touch insulating layer 730. The second touch electrode 740_T adjacent in the second direction (or the Y-axis direction) may be connected by the second touch connection electrode. The second touch electrode 740_T and the second touch connection electrode may be formed on the same layer.

A touch planarization layer may be disposed on the touch insulating layer 730, the first touch electrode 740_R, the second touch electrode 740_T, and the second touch connection electrode.

The touch planarization layer may be disposed so as to cover the touch insulating layer 730, the first touch electrode 740_R, the second touch electrode 740_T, and the second touch connection electrode.

The touch planarization layer may be formed of at least one of an acrylic resin, an epoxy resin, a phenol resin, a polyamide resin, a polyimide resin, an unsaturated polyester resin, a polyphenylene resin, and a polyphenylene sulfide resin, but is not limited thereto.

A touch line 750 may be disposed in the non-active area NA. The touch line 750 may include a first touch line 751 and a second touch line 752. The touch line 750 may be disposed as a double line of the first touch line 751 and the second touch line 752.

The first touch line 751 may be disposed on the touch buffer layer 710. The first touch line 751 stably supplies a signal even though the second touch line 752 is disconnected by the external impact and may be electrically connected to the second touch line 752 so as to reduce a resistance of the second touch line 752 which transmits a signal of the touch driver to the first touch block Rx and the second touch block Tx. For example, the first touch line 751 may be electrically connected to the second touch line 752 by means of the hole of the touch insulating layer 730.

A touch insulating layer 730 may be disposed on the first touch line 751. When the touch insulating layer 730 is formed on the first touch connection electrode 720 disposed in the active area AA, the touch insulating layer 730 may be simultaneously formed of the same material by the same process, but it is not necessarily limited thereto. Therefore, a separate process may be performed during the process and the patterning may be performed.

At least one part of the first touch line 751 and the second touch line 752 may be disposed to overlap.

The touch insulating layer 730 may further include a plurality of holes which exposes at least a part of the first touch line 751.

The first touch line 751 disposed below the touch insulating layer 730 and the second touch line 752 disposed above the touch insulating layer 730 may be electrically connected by means of the hole of the touch insulating layer 730.

The second touch line 752 may be disposed on the touch insulating layer 730. The second touch line 752 may transmit a signal from an external module which is attached or bonded to the touch driver to the first touch block Rx and the second touch block Tx.

The second touch line 752 may be formed of the same material and by the same process as the first touch electrode 740_R, the second touch electrode 740_T, and the second touch connection electrode disposed in the active area AA, but is not limited thereto.

A touch planarization layer may be further disposed on the second touch line 752. The touch planarization layer may be disposed to cover the second touch line 752. The touch planarization layer may planarize an upper portion of the second touch line 752.

The touch planarization layer may be formed of the same material and by the same process as the touch planarization layer disposed in the active area AA, but is not limited thereto.

The light emitting display apparatus 100 in which a plurality of touch lines 750 is disposed on the protection layer 300 has a problem in that a touch sensitivity at an outer peripheral area A of the light emitting display apparatus 100 is lowered due to a low thickness and/or steep inclination and a step of the protection layer 300 in the non-active area NA adjacent to the active area AA of the light emitting display apparatus 100. For example, the protection layer 300 of the active area AA has a uniform thickness. To the contrary, in the protection layer 300 formed in the non-active area NA adjacent to the active area AA, a steep inclination and step may be formed because the planarization layer, the insulating layer, and the metal line disposed below the protection layer 300 are etched. Therefore, there is a problem in that the moving speed of the organic material of the second protection layer 320 is increased so that a thickness is reduced before the second protection layer 320 is hardened and the second protection layer 320 is not applied.

The protection layer 300 formed to have a small thickness in the non-active area NA adjacent to the active area AA causes the electric field interference of the electrodes and the wiring lines disposed above and below the protection layer 300, which results in the degradation of the display quality and the lowering of the touch sensitivity.

Further, when the touch line 750 is manufactured with the steep inclination and step of the protection layer 300 in the non-active area NA, if the touch line 750 is formed in an area in which the inclination or the step of the protection layer 300 is formed, there is a problem such as the loss or disconnection of the touch line.

Therefore, the inventors of the present disclosure conducted several experiments to reduce the lowering of the display quality and the touch sensitivity in the non-active area NA adjacent to the active area AA. Several experiments have been conducted to improve a display quality and improve a touch sensitivity by minimizing electric field interference of the electrode disposed above and below the protection layer 300 in the non-active area NA adjacent to the active area AA.

The first pattern 400 formed in the first part P1 of the non-active area NA adjacent to the active area AA suppresses the flow of the organic material of the second protection layer 320 to make the thickness of the second protection layer 320 formed in the first part P1 large. The protection layers 320 are formed to have similar thicknesses in the first parts P1 in the active area AA and the non-active area NA. Therefore, it is possible to suppress the increase of the parasitic capacitance Cp formed in the non-active area NA adjacent to the active area AA in the related art and improve the display quality and a sensitivity of the touch sensing.

The touch line 750 may be disposed to overlap the first pattern 400, the second pattern 500, and the dam 600.

The touch line 750 may be disposed to be spaced apart from the first pattern 400, the second pattern 500, and the dam 600 without overlapping at least a part thoseof. For example, the touch line 750 may be disposed so as not to at least partially overlap the first pattern 400 and the dam 600. The touch line 750 may be disposed to at least partially overlap the second pattern 500.

The touch line 750 may be spaced apart from the first pattern 400 with a first distance D1 therebetween and may be spaced apart from the dam 600 with a second distance D2 therebetween. The first distance D1 and the second distance D2 may be equal to each other or different from each other. When the first distance D1 and the second distance D2 are different, the second distance D2 may be larger than the first distance D1.

The protective scope of the present disclosure should be construed based on the following claims.

## Claims

1. A light emitting display apparatus, comprising:
a substrate (110) including an active area (AA) and a non-active area (NA) adjacent to the active area (AA);
a planarization layer (130) in the active area (AA) and in a first part (P1) of the non-active area (NA);
a first pattern (400) disposed on the planarization layer (130);
a bank layer (220) disposed on the planarization layer (130);
a second pattern (500) and a dam (600) disposed in a second part (P2) adjacent to the first part (P1) of the non-active area (NA) and having different heights;
a protection layer (300) disposed in the active area (AA) and the non-active area (NA), wherein the protection layer (300) includes a first and a second protection layer (310, 320), and the second protection layer (320) is formed by an organic material,
the organic material is configured to overflow the first pattern (400),
**characterized by** the first pattern (400) is formed on the bank layer (220) formed on the planarization layer (130), and
wherein the height of an upper surface of the first pattern (400) with respect to an upper surface of the substrate (110) is higher than the height of an upper surface of the second pattern (500) and an upper surface of the dam (600) with respect to the upper surface of the substrate (110).

2. The light emitting display apparatus of claim 1, wherein the planarization layer (130) extends from the active area (AA) to the first part (P1) of the non-active area (NA).

3. The light emitting display apparatus of claim 1 or 2, wherein the second pattern (500) is spaced apart from the first pattern (400) and the dam (600) or is disposed between the first pattern (400) and the dam (600) and/or the second pattern (500) is formed of the same material as the planarization layer (130).

4. The light emitting display apparatus of any one of the preceding claims, further comprising a spacer (250) disposed on a bank layer (220), wherein the first pattern (400) is located on the same layer as the spacer (250) and/or the spacer (250) and the bank layer (220) are formed of the same material and/or at least one metal layer disposed above the second pattern (500).

5. The light emitting display apparatus of any one of the preceding claims, wherein vertical heights of the first pattern (400) and the second pattern (500) are lower than a vertical height of the dam (600).

6. The light emitting display apparatus of any one of the preceding claims, wherein the dam (600) includes at least one material among the materials used to dispose the planarization layer (300), the bank layer (220), and the spacer (250).

7. The light emitting display apparatus of any one of the preceding claims, wherein the number of each of the first pattern (400) and the second pattern (500) is two or larger and/or the number of dams (600) is smaller than the number of the first patterns (400) and the second patterns (500).

8. The light emitting display apparatus of claim 1, wherein at least a part of the second protection layer (320) is disposed between the second pattern (500) and the dam (600).

9. The light emitting display apparatus of claim 1 or 8, further comprising a touch line (750) disposed on the protection layer (300) and/or the touch line (750) is spaced apart from a part of at least one of the first pattern (400) and the dam (600) and/or the touch line (750) overlaps at least a part of the second pattern (500).

10. The light emitting display apparatus of any one of the preceding claims, further comprising a first touch electrode and a second touch electrode (740) disposed in the active area (AA) and/or a first touch electrode and a second touch electrode are configured to sense touch by sensing a variation of a mutual capacitance Cm formed between the first touch electrode and the second touch electrode (740).

11. The light emitting display apparatus of any one of the preceding claims, further comprising a buffer hole (BH) disposed on the planarization layer (130) or an anode electrode (210) in the first part (P1) of the non-active area (NA).

12. The light emitting display apparatus of any one of the preceding claims, further comprising a driving circuit (ESD, MUX), wherein the first pattern (400), the second pattern (500), and the dam (600) are disposed between the active area (AA) and the driving circuit (ESD, MUX).

13. The light emitting display apparatus of claim 12, wherein the driving circuit includes at least one multiplex (MUX), an electrostatic discharge (ESD) circuit, a high potential voltage line (VDD), or a low potential voltage line (VSS) and, the first pattern (400), the second pattern (500), and the dam (600) are disposed between the active area (AA) and the multiplexer (MUX), the electrostatic discharge (ESD) circuit, the high potential voltage line (VDD), or the low potential voltage line (VSS).

14. The light emitting display apparatus of any one of the preceding claims, further comprising:
a gate driving circuit (112) disposed in the non-active area (NA), wherein the gate driving circuit (112) is disposed between the active area (AA) and the first pattern (400), the second pattern (500), or the dam (600).

## Patentansprüche

1. Lichtemittierende Anzeigevorrichtung, die Folgendes umfasst:
ein Substrat (110), das einen aktiven Bereich (AA) und einen nicht aktiven Bereich (NA), der zum aktiven Bereich (AA) benachbart ist, enthält;
eine Planarisierungsschicht (130) im aktiven Bereich (AA) und in einem ersten Abschnitt (P1) des nicht aktiven Bereichs (NA);
ein erstes Muster (400), das auf der Planarisierungsschicht (130) angeordnet ist;
eine Bankschicht (220), die auf der Planarisierungsschicht (130) angeordnet ist;
ein zweites Muster (500) und einen Damm (600), die in einem zweiten Abschnitt (P2) angeordnet sind, der zum ersten Abschnitt (P1) des nicht aktiven Bereichs (NA) benachbart ist, und verschiedene Höhen aufweisen; und
eine Schutzschicht (300), die in dem aktiven Bereich (AA) und dem nicht aktiven Bereich (NA) angeordnet ist, wobei die Schutzschicht (300) eine erste und eine zweite Schutzschicht (310, 320) enthält und die zweite Schutzschicht (320) durch ein organisches Material gebildet ist, wobei
das organische Material konfiguriert ist, über das erste Muster (400) zu laufen,
**dadurch gekennzeichnet, dass** das erste Muster (400) auf der Bankschicht (220) gebildet ist, die auf der Planarisierungsschicht (130) gebildet ist,
wobei die Höhe einer oberen Oberfläche des ersten Musters (400) in Bezug auf eine obere Oberfläche des Substrats (110) größer als die Höhe einer oberen Oberfläche des zweiten Musters (500) und einer oberen Oberfläche des Damms (600) in Bezug auf die obere Oberfläche des Substrats (110) ist.

2. Lichtemittierende Anzeigevorrichtung nach Anspruch 1, wobei die Planarisierungsschicht (130) vom aktiven Bereich (AA) zum ersten Abschnitt (P1) des nicht aktiven Bereichs (NA) verläuft.

3. Lichtemittierende Anzeigevorrichtung nach Anspruch 1 oder 2, wobei das zweite Muster (500) von dem ersten Muster (400) und dem Damm (600) beabstandet ist oder zwischen dem ersten Muster (400) und dem Damm (600) angeordnet ist und/oder das zweite Muster (500) aus demselben Material wie die Planarisierungsschicht (130) gebildet ist.

4. Lichtemittierende Anzeigevorrichtung nach einem der vorhergehenden Ansprüche, die ferner einen Abstandshalter (250) umfasst, der auf einer Bankschicht (220) angeordnet ist, wobei das erste Muster (400) sich auf derselben Schicht wie der Abstandshalter (250) befindet und/oder der Abstandshalter (250) und die Bankschicht (220) aus demselben Material und/oder mindestens einer Metallschicht, die über dem zweiten Muster (500) angeordnet ist, gebildet sind.

5. Lichtemittierende Anzeigevorrichtung nach einem der vorhergehenden Ansprüche, wobei vertikale Höhen des ersten Musters (400) und des zweiten Musters (500) kleiner als eine vertikale Höhe des Damms (600) sind.

6. Lichtemittierende Anzeigevorrichtung nach einem der vorhergehenden Ansprüche, wobei der Damm (600) mindestens ein Material unter den Materialien enthält, die verwendet werden, um die Planarisierungsschicht (300), die Bankschicht (220) und den Abstandshalter (250) anzuordnen.

7. Lichtemittierende Anzeigevorrichtung nach einem der vorhergehenden Ansprüche, wobei die Anzahl jedes des ersten Musters (400) und des zweiten Musters (500) zwei oder mehr ist und/oder die Anzahl von Dämmen (600) kleiner als die Anzahl der ersten Muster (400) und der zweiten Muster (500) ist.

8. Lichtemittierende Anzeigevorrichtung nach Anspruch 1, wobei mindestens ein Abschnitt der zweiten Schutzschicht (320) zwischen dem zweiten Muster (500) und dem Damm (600) angeordnet ist.

9. Lichtemittierende Anzeigevorrichtung nach Anspruch 1 oder 8, die ferner eine Berührungsleitung (750) umfasst, die auf der Schutzschicht (300) angeordnet ist, und/oder wobei die Berührungsleitung (750) von einem Abschnitt mindestens eines des ersten Musters (400) und des Damms (600) beabstandet ist und/oder wobei die Berührungsleitung (750) mit mindestens einem Abschnitt des zweiten Musters (500) überlappt.

10. Lichtemittierende Anzeigevorrichtung nach einem der vorhergehenden Ansprüche, die ferner eine erste Berührungselektrode und eine zweite Berührungselektrode (740) umfasst, die im aktiven Bereich (AA) angeordnet sind, und/oder wobei eine erste Berührungselektrode und eine zweite Berührungselektrode konfiguriert sind, eine Berührung durch Erfassen einer Schwankung einer Gegenkapazität Cm, die zwischen der ersten Berührungselektrode und die zweite Berührungselektrode (740) gebildet ist, zu erfassen.

11. Lichtemittierende Anzeigevorrichtung nach einem der vorhergehenden Ansprüche, die ferner ein Pufferloch (BH) umfasst, das auf der Planarisierungsschicht (130) oder einer Anodenelektrode (210) im ersten Abschnitt (P1) des nicht aktiven Bereichs (NA) angeordnet ist.

12. Lichtemittierende Anzeigevorrichtung nach einem der vorhergehenden Ansprüche, die ferner eine Ansteuerschaltung (ESD, MUX) umfasst, wobei das erste Muster (400), das zweite Muster (500) und der Damm (600) zwischen dem aktiven Bereich (AA) und der Ansteuerschaltung (ESD, MUX) angeordnet sind.

13. Lichtemittierende Anzeigevorrichtung nach Anspruch 12, wobei die Ansteuerschaltung mindestens ein Multiplex (MUX), eine Schaltung zur elektrostatischen Entladung (ESD-Schaltung), eine Hochpotentialspannungsleitung (VDD) oder eine Niederpotentialspannungsleitung (VSS) enthält und
das erste Muster (400), das zweite Muster (500) und der Damm (600) zwischen dem aktiven Bereich (AA) und dem Multiplexer (MUX), der Schaltung zur elektrostatischen Entladung (ESD-Schaltung), der Hochpotentialspannungsleitung (VDD) oder der Niederpotentialspannungsleitung (VSS) angeordnet sind.

14. Lichtemittierende Anzeigevorrichtung nach einem der vorhergehenden Ansprüche, die ferner Folgendes umfasst:
eine Gate-Ansteuerschaltung (112), die im nicht aktiven Bereich (NA) angeordnet ist, wobei die Gate-Ansteuerschaltung (112) zwischen dem aktiven Bereich (AA) und dem ersten Muster (400), dem zweiten Muster (500) oder dem Damm (600) angeordnet ist.

## Revendications

1. Appareil d'affichage électroluminescent, comportant :
un substrat (110) incluant une zone active (AA) et une zone non-active (NA) adjacente à la zone active (AA) ;
une couche de planarisation (130) dans la zone active (AA) et dans une première partie (P1) de la zone non-active (NA) ;
un premier motif (400) disposé sur la couche de planarisation (130) ;
une couche de banc (220) disposée sur la couche de planarisation (130) ;
un second motif (500) et un barrage (600) disposés dans une seconde partie (P2) adjacente à la première partie (P1) de la zone non-active (NA) et ayant différentes hauteurs ;
une couche de protection (300) disposée dans la zone active (AA) et la zone non-active (NA), dans lequel la couche de protection (300) inclut une première et une seconde couche de protection (310, 320), et la seconde couche de protection (320) est formée par un matériau organique,
le matériau organique est configuré pour déborder du premier motif (400),
**caractérisé en ce que** le premier motif (400) est formé sur la couche de banc (220) formée sur la couche de planarisation (130), et
dans lequel la hauteur d'une surface supérieure du premier motif (400) par rapport à une surface supérieure du substrat (110) est supérieure à la hauteur d'une surface supérieure du second motif (500) et d'une surface supérieure du barrage (600) par rapport à la surface supérieure du substrat (110).

2. Appareil d'affichage électroluminescent selon la revendication 1, dans lequel la couche de planarisation (130) s'étend de la zone active (AA) à la première partie (P1) de la zone non-active (NA).

3. Appareil d'affichage électroluminescent selon la revendication 1 ou 2, dans lequel le second motif (500) est espacé du premier motif (400) et du barrage (600) ou est disposé entre le premier motif (400) et le barrage (600) et/ou le second motif (500) est formé du même matériau que la couche de planarisation (130).

4. Appareil d'affichage électroluminescent selon l'une quelconque des revendications précédentes, comportant en outre un élément d'espacement (250) disposé sur une couche de banc (220), dans lequel le premier motif (400) est situé sur la même couche que l'élément d'espacement (250) et/ou l'élément d'espacement (250) et la couche de banc (220) sont formés du même matériau et/ou d'au moins une couche métallique disposée au-dessus du second motif (500).

5. Appareil d'affichage électroluminescent selon l'une quelconque des revendications précédentes, dans lequel des hauteurs verticales du premier motif (400) et du second motif (500) sont inférieures à une hauteur verticale du barrage (600).

6. Appareil d'affichage électroluminescent selon l'une quelconque des revendications précédentes, dans lequel le barrage (600) inclut au moins un matériau parmi les matériaux utilisés pour disposer la couche de planarisation (300), la couche de banc (220) et l'élément d'espacement (250).

7. Appareil d'affichage électroluminescent selon l'une quelconque des revendications précédentes, dans lequel le nombre de chaque motif parmi le premier motif (400) et le second motif (500) est deux ou plus et/ou le nombre de barrages (600) est inférieur au nombre des premiers motifs (400) et des seconds motifs (500).

8. Appareil d'affichage électroluminescent selon la revendication 1, dans lequel au moins une partie de la seconde couche de protection (320) est disposée entre le second motif (500) et le barrage (600).

9. Appareil d'affichage électroluminescent selon la revendication 1 ou 8, comportant en outre une ligne tactile (750) disposée sur la couche de protection (300) et/ou la ligne tactile (750) est espacée d'une partie d'au moins un élément parmi le premier motif (400) et le barrage (600) et/ou la ligne tactile (750) chevauche au moins une partie du second motif (500).

10. Appareil d'affichage électroluminescent selon l'une quelconque des revendications précédentes, comportant en outre une première électrode tactile et une seconde électrode tactile (740) disposées dans la zone active (AA) et/ou une première électrode tactile et une seconde électrode tactile sont configurées pour détecter un toucher en détectant une variation d'une capacité mutuelle Cm formée entre la première électrode tactile et la seconde électrode tactile (740).

11. Appareil d'affichage électroluminescent selon l'une quelconque des revendications précédentes, comportant en outre un trou de tampon (BH) disposé sur la couche de planarisation (130) ou une électrode d'anode (210) dans la première partie (P1) de la zone non-active (NA).

12. Appareil d'affichage électroluminescent selon l'une quelconque des revendications précédentes, comportant en outre un circuit d'attaque (ESD, MUX), dans lequel le premier motif (400), le second motif (500) et le barrage (600) sont disposés entre la zone active (AA) et le circuit d'attaque (ESD, MUX).

13. Appareil d'affichage électroluminescent selon la revendication 12, dans lequel le circuit d'attaque inclut au moins un multiplex (MUX), un circuit de décharge électrostatique (ESD), une ligne de tension à potentiel élevé (VDD) ou une ligne de tension à faible potentiel (VSS) et,
le premier motif (400), le second motif (500) et le barrage (600) sont disposés entre la zone active (AA) et le multiplexeur (MUX), le circuit de décharge électrostatique (ESD), la ligne de tension à potentiel élevé (VDD) ou la ligne de tension à faible potentiel (VSS).

14. Appareil d'affichage électroluminescent selon l'une quelconque des revendications précédentes, comportant en outre :
un circuit d'attaque de grille (112) disposé dans la zone non-active (NA), dans lequel le circuit d'attaque de grille (112) est disposé entre la zone active (AA) et le premier motif (400), le second motif (500) ou le barrage (600).
